Europäisches Patentamt

European Patent Office

Office européen des brevets

(11) Publication number: **0 225 131**
**A2**

# (12) EUROPEAN PATENT APPLICATION

(21) Application number: **86309085.8**

(22) Date of filing: **20.11.86**

(51) Int. Cl.⁴: **H 01 L 33/00**

(30) Priority: **29.11.85 US 802979   29.11.85 US 802978**

(43) Date of publication of application:
**10.06.87   Bulletin 87/24**

(84) Designated Contracting States: **DE FR GB IT NL**

(71) Applicant: **AMERICAN TELEPHONE AND TELEGRAPH COMPANY**
**550 Madison Avenue**
**New York, NY 10022 (US)**

(72) Inventor: **Bock, Anne Barbara**
**R.D. 3 Box 475**
**Kutztown Pennsylvania 19530 (US)**

**Kurtz, Samuel Eugene**
**3120 Eisenbrown Road**
**Reading Pennsylvania 19605 (US)**

**Seibert, Thomas Edward**
**1400 North Fourteenth Street**
**Reading Pennsylvania 19604 (US)**

(74) Representative: **Watts, Christopher Malcolm Kelway, Dr. et al**
**Western Electric Company Limited 5, Mornington Road**
**Woodford Green Essex, IG8 0TU (GB)**

(54) Semiconductor light emitting device and method of forming same.

(57)   An assembly for a light emitting device is disclosed which utilizes a lens (22) formed in direct contact with both the light emitting device and its supporting mount structure so as to completely encapsulate the device and substantially cover the top major surface of the mount. The lens is applied in liquid form and naturally flows to assume a convex structure and encapsulate the emitting device. Due to its viscosity, the lens material, as it flows, will conform in shape to the dimensions of the mount. In a preferred process, the lens material is applied to the assembly by means of a printing fixture (30) including a dependent pin (32) for transferring a drop (36) of the material to the assembly.

EP 0 225 131 A2

**Description**

SEMICONDUCTOR LIGHT EMITTING DEVICE AND METHOD OF FORMING SAME

Background of the Invention

Semiconductor light emitting diodes have found ever-increasing use as replacements for filament bulbs in a wide variety of applications. Their small size, low power consumption and long life make them attractive for such uses as indicator lamps in key telephone sets and switchboards. Careful consideration must be given in such uses for distributing the light to produce maximum impact on the viewer. Of the light emitted by a p-n junction, only a small fraction exits through the surface of the diode, due to the "critical angle" of the diode material whereby most of the light becomes reflected and absorbed within the diode material. In this regard, the small size of the diode (approximately ll mils on each side) is a drawback since light is emitted from too small of an area for good viewing. To overcome this problem, it is necessary to spread the light over a larger area while maintaining a sufficient brightness. This may be accomplished, for example, by placing the LED within a cavity which has formed therein a plurality of spherical lenses as disclosed in U.S. Patent 4,013,915 issued to W. H. Dufft on March 22, 1977. The lens arrangement thus produces an array of discrete images which, when combined, enhance visibility and permit good off-axis viewing. Although this arrangement does indeed improve the attributes of the LED, large scale production of LEDs with the plural spherical structure would be extremely time-consuming and expensive.

An alternative arrangement is disclosed in U. S. Patent 3,805,347 issued to N. E. Collins et al on April 23, 1974. In the Collins et al arrangement, an epoxy material with a convex mensicus surface is placed over the diode element. This epoxy material functions both to increase the critical angle of the diode (and hence the amount of light emitted from the diode) and also to focus this increased amount of light toward the lens, the lens being removed a substantial distance from the surface of the diode. As a variation of this technique, a viscous monomer is placed in the lens cap, prior to the lens cap being fitted onto the diode. When mated, the viscous material will deform by gravity to surround the diode and form a conical light director between the diode and the lens.

Although these and other prior art techniques have been helpful in improving the quality of LEDs, their use in large volume production is limited, since a number of processing steps are required to form this additional material over the diode and to subsequently place the lens cap over the arrangement, where alignment between the lens and the diode is an important consideration. Therefore, a need remains in the prior art for an LED assembly with the required characteristics described above which can be produced in a large-scale manufacture environment.

Summary of the Invention

A light emitting device is provided comprising a direct contact lens structure, the structure preferably being formed by directly printing a liquid lens material onto the emitting device. The material naturally flows to assume a convex shape and completely encapsulates the LED and a substantial portion of its associated mounting structure.

Brief Description of the Drawings

FIG. l illustrates an LED assembly with a direct contact lens formed using the method of the present invention;

FIG. 2 illustrates an exemplary LED mount without a lens and an associated structure used in the method of the present invention to print the lens onto the mount; and

FIG. 3 illustrates an array of LED mounts and a printing structure capable of simultaneously forming an array of lenses in accordance with the method of present invention.

Detailed Description

An exemplary embodiment of an LED assembly l0 formed using the method of the present invention is illustrated in FIG. l. A light emitting diode l2 is shown and may comprise a gallium phosphide (GaP) chip which emits light in response to an applied bias. The chip usually comprises n-type GaP upon which is grown a layer of p-type GaP which includes dopants of zinc and oxygen to provide recombination centers. However, it is to be understood that any suitable compound may be utilized to form the light emitting device. Further, diode l2, which may also be referred to as the "die" or "chip", is illustrated as a single block for the sake of simplicity. Electrical contact is made to the bottom of diode l2 by a metal contact l4, as shown in FIG. l. LED assembly l0 includes a base l6, which may be a thermoplastic, or other insulating material. Metal contact l4 is mounted on the top major surface of base l6, where contact l4 may be adhered to base l6 with an epoxy material. The remaining electrical connection to the top of diode l2 is made by a metal contact l8, also referred to as a ribbon contact l8, which is connected to a metal contact 20 attached to base l6 as shown. Positive and negative signals may then be connected to leads 20 and l4 to activate diode l2 and initiate light emission. In accordance with the present invention, a lens 22 is formed over base l6 so as to encapsulate various portions of the assembly.

This lens structure of the present invention differs significantly from prior art arrangements where the lens is formed in a separate cap piece which is mounted on base l6. In these prior art arrangements, therefore, the lens will be separated from the diode by the internal cavity between the diode and the lens cap. In contrast, the arrangement of the present invention utilizes a lens which is in intimate contact with the diode. Preferably, the lens is formed by dropping a liquid epoxy material onto the surface of

base 16 and allowing the epoxy to flow to conform to the top surface shape of base 16. Any suitable epoxy material may be utilized to form the lens encapsulant, so long as the refractive index of the liquid is greater than unity.

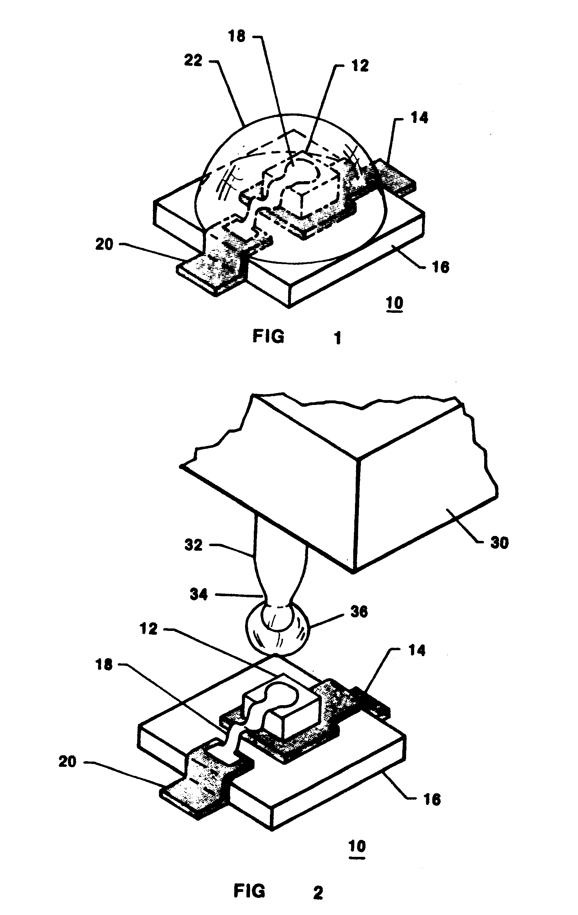

The arrangement illustrated in FIG. 1 comprises a square-shaped base 16. However, base 16 may comprise any desired shape (for example, round or rectangular) where, as stated above, lens encapsulant 22 will naturally flow to conform with the structure. In accordance with its natural viscosity, the lens material will retain convex lens structure necessary to direct the light transmission from diode 12. Once the lens material has sufficiently covered both diode 12 and base 16, assembly 10 is cured to harden the lens material. Compared with prior art arrangements, the lens structure of the present invention will naturally comprise a lower profile, since the lens is in direct contact with the diode. This lower profile provides a significantly increased horizontal viewing angle, denoted $\alpha$ in FIG. 1, where an angle of approximately 75 degrees may be obtained. Additionally, as is discussed hereinafter, the procedure of forming a large array of LED assemblies utilizing the method of the present invention is greatly simplified over that of the prior art.

In fact, utilizing the method of the present invention allows for arrays of LEDs to be formed during a single manufacturing cycle. To form these LED arrays, a unique method of forming the lens encapsulate on the diode base has been developed. In particular, a printing structure 30, as shown in FIG. 2, is utilized which includes a vertical pin 32 extending downward from the bottom major surface of printing structure 30. As shown in FIG. 2, pin 32 may comprise a tapered section 34 at its tip. After the electrical contacts have been made to diode 12, where the attachment of ribbon 18 is usually the last step in this process, printing structure 30 is dipped into a bath of epoxy material (not shown) and subsequently removed so that a small amount of the epoxy adheres to the tip of pin 32, shown as epoxy droplet 36 in FIG. 2. It is to be understood that any liquid epoxy material with an index of refraction greater than 1 may be used in forming the bath required to practice the present invention. In fact, different color LEDs may easily be formed in accordance with the present invention simply by having a number of different baths (for example, red, yellow, and green) all available for use. Using the method of the present invention, printing structure 30 is placed over base 16 and lowered in the direction shown by the arrows in FIG. 2 such that the tip of pin 32 comes in contact with ribbon 18. As soon as contact is made, printing structure 30 is raised, and the droplet of epoxy 36 will adhere to the diode assembly. Droplet 36 will then flow to completely encapsulate diode 12 as well as contact 14 and 18. A substantial amount of the epoxy will also cover contact 20 and the top major surface of base 16, as can be seen by reference to the completed structure in FIG. 1. To complete the manufacturing process, assembly 10 is cured to harden the lens material, where lens 22 will naturally assume the required convex lens structure.

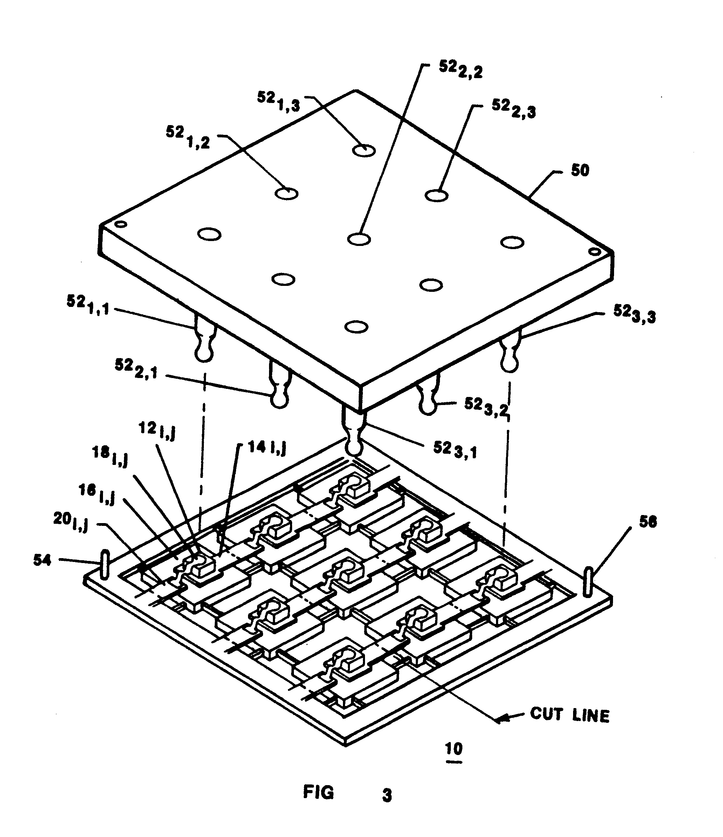

Utilizing this technique of forming the lens on the diode assembly, it is fairly simple to "print" a large array of diodes in a single manufacturing step. One such arrangement is illustrated in FIG. 3, which shows for the sake of simplicity a $3 \times 3$ diode array 10. In the actual practice of the present invention, array of the size $100 \times 100$ can easily be formed. Each individual diode assembly illustrated in FIG. 3 is identical to that of FIG. 1, where subscripts have been added to the numerals simply to define the placement of the individual diodes in the rows and columns of the array. The lens material may be printed on this array assembly using a printing structure 50 as shown, which includes an array of vertical pins $52_{1,1}$ through $52_{3,3}$, disposed as shown such that each pin is associated with a separate diode element. As with the above-described single lens manufacture procedure, printing structure 50 may be dipped into an epoxy bath and then transferred to the array structure. The two-step motion of lowering and then raising structure 50 will thus print an array of lens encapsulants over diode assembly 40. For this particular arrangement, alignment between the diode array and the printing structure may be assured by performing all of the manufacturing steps in the same mounting fixture, where a set of mounting pins 54 and 56, as shown in FIG. 3, will ensure adequate alignment.

## Claims

1. a method of forming a light emitting device CHARACTERIZED BY:

    a. lowering a printing structure (30) including a downwardly extending vertical pin (32) into a bath of a liquid lens material;

    b. removing said printing structure from said bath so that a drop (36) of lens material adheres to said vertical pin;

    c. lowering said printing structure over a workpiece comprising a light emitting element (12) mounted on a base (16) so that said drop of lens material contacts a top portion of said element;

    d. raising said printing structure in a manner such that said drop of lens material adheres to said element and flows to substantially cover both said element and portions of said base to form a direct contact lens for said light emitting device; and

    e. curing said material to harden the said direct contact lens in its final form.

2. The method of claim 1 in which the vertical pin comprises a tapered tip section (34) so as to allow a sufficient amount of lens material to adhere to said vertical pin to provide substantial coverage of both the element and the underlying surface of the base.

3. The method of claim 1 wherein the bath of liquid lens material comprises a liquid epoxy material.

4. A semiconductor light emitting device assembly comprising

a light emitting diode (12) mounted on a base (16)

mounting means (14,20) for holding said light emitting diode on a surface of said base;

CHARACTERIZED BY

a lens (22) disposed in direct contact with both said diode and said mounting means such that said lens fully encapsulates said diode and substantially covers said surface of said base.

5. A semiconductor light emitting device assembly as defined in claim 4 wherein said lens comprises a hardened liquid epoxy.

18
22
12
14
20
16
10

**FIG       1**

30
32
34
36
12
18
14
20
16
10

**FIG       2**

0225131

$52_{1,3}$
$52_{2,2}$
$52_{1,2}$
$52_{2,3}$
50
$52_{1,1}$
$52_{3,3}$
$52_{2,1}$
$52_{3,2}$
$12_{i,j}$
$18_{i,j}$
$14_{i,j}$
$16_{i,j}$
$52_{3,1}$
$20_{i,j}$
56
54
CUT LINE
10

FIG     3